# EUROPEAN PATENT APPLICATION

(11) **EP 4 664 514 A1**
(43) Date of publication of application: **17.12.2025**
(21) Application number: 25179630.6
(22) Date of filing: 28.05.2025
(51) Int. Cl.: H01L 23/00

(54) **PRECISION BOND HEAD ALIGNMENT UTILIZING A UNIVERSAL REFERENCE PLATE**

(30) Priority: 06.06.2024 US 202418735494
(71) Applicant: ASMPT Singapore Pte. Ltd., Singapore 768924 (SG)
(72) Inventor: DENG, Jiang Wen, Tsing Yi, N.T. (HK); LEUNG, Wing Hong, Tsing Yi, N.T. (HK); HUNG, Fan Hei Kevin, Tsing Yi, N.T. (HK); LIU, Chun Ki Sam, Tsing Yi, N.T. (HK); CHANG, Hei Lam, Tsing Yi, N.T. (HK)
(74) Representative: Emerson, Peter James

(57) **Abstract**

A semiconductor die is picked up with a collet, which is then located between first and second camera systems. The first camera system views the collet and a reference plate, and the second camera system views the semiconductor die and the reference plate, in order to determine a position and orientation of the semiconductor die relative to the collet and the reference plate. Thereafter, the collet is moved to a position above a bonding position on a substrate, and the first camera system views the bonding position so that the position and orientation of the semiconductor die may be adjusted before the semiconductor die is bonded onto the bonding position.

## Description

### Field of the Invention

The invention relates to semiconductor die bonding, and in particular, to conducting die bonding with improved precision and accuracy during die bonding operations.

### Background and Prior Art

During die bonding operations, there are different types of offsets to be determined and corrected to ensure that a semiconductor die is accurately bonded onto a bonding position on a substrate. One offset is an offset between the semiconductor die and the bonding position, while another is an offset between the bonding position and a collet or bond head holding the semiconductor die.

The amounts of such offsets are typically obtained by capturing images of the bond head and the semiconductor die using a first vision system, and then capturing images of the bond head and the substrate using a second vision system. However, after conducting multiple bonding operations, object positions in the images captured would shift due to factors such as module deformation, thermal drift and so on. Therefore, reduced camera calibration accuracy and optical aberration would tend to limit the bonding accuracy when analyzing the aforesaid images that are captured after a bonding apparatus has been operating for some time. These images would no longer by themselves be an accurate indication of the prevailing offsets.

In some conventional systems, a vision system with a small numerical aperture and a large depth of field is deployed in the vision system to be able to view the semiconductor die and the substrate within the same image. Alternatively, the bonding speed may have to be lowered in order to ensure a higher degree of bonding accuracy.

One approach to achieve higher bonding accuracy is described in US patent number 10,861,819 B2 entitled "High Precision Bond Head Positioning System and Apparatus". Nevertheless, the apparatus may still suffer from tilting of the bond head or the optical systems used in the vision systems, which might be unaccounted for and adversely affect alignment accuracy. Moreover, an object position in the image may also shift after a period of use, not to mention any inherent optical distortion and aberration in the optical system which would also affect alignment accuracy.

It would be beneficial to develop an alignment method and apparatus that avoids the aforesaid shortcomings of the prior art.

### Summary of the Invention

It is thus an object of the invention to seek to provide an alignment method and apparatus that accurately determines and corrects alignment offsets notwithstanding the typical problems faced by the usage of prior art approaches.

According to a first aspect of the invention, there is provided a method of bonding a semiconductor die onto a bonding position on a surface, the method comprising the steps of: picking up the semiconductor die with a collet; locating the collet between a first camera system and a second camera system; viewing the collet and a reference plate with the first camera system and determining a position and orientation of the collet relative to the reference plate when the collet is holding the semiconductor die; viewing the semiconductor die and the reference plate with the second camera system and determining a position and orientation of the semiconductor die relative to the reference plate; moving the collet to a position above the bonding position; viewing the bonding position with the first camera system and determining a position and orientation of the bonding position relative to the position and orientation of the collet and the position and orientation of the semiconductor die; and thereafter adjusting the position and orientation of the semiconductor die with the collet and bonding the semiconductor die onto the bonding position.

According to a second aspect of the invention, there is provided an apparatus for bonding a semiconductor die onto a bonding position on a surface, the apparatus comprising: a collet for picking up the semiconductor die; a first camera system and a second camera system; and a reference plate; wherein when the collet is holding the semiconductor die between the first and second camera systems, the first camera system is operative to view the collet and the reference plate for determining a position and orientation of the collet relative to the reference plate and the second camera system is operative to view the semiconductor die and the reference plate for determining a position and orientation of the semiconductor die relative to the reference plate; and wherein when the collet is moved to a position above the bonding position, the first camera system is further operative to view the bonding position for determining a position and orientation of the bonding position relative to the position and orientation of the collet and the position and orientation of the semiconductor die prior to adjusting the position and orientation of the semiconductor die with the collet and bonding the semiconductor die onto the bonding position.

It would be convenient hereinafter to describe the invention in greater detail by reference to the accompanying drawings which illustrate specific preferred embodiments of the invention. The particularity of the drawings and the related description is not to be understood as superseding the generality of the broad identification of the invention as defined by the claims.

### Brief Description of the Drawings

A specific example of an alignment method and apparatus in accordance with the invention will now be described with reference to the accompanying drawings, in which:
FIG. 1A is a side view of a die alignment system according to the preferred embodiment of the invention, wherein both a first down-look camera and an up-look camera are viewing a reference plate, and FIG. 1B is a side view of the die alignment system wherein the up-look camera is viewing the die as well as the reference plate;
FIGs. 2A to 2C illustrate exemplary images captured by the first down-look and up-look cameras in a vicinity of one corner of the die when conducting a die pre-alignment process according to the preferred embodiment of the invention;
FIGs. 2D to 2E illustrate exemplary images captured by a second down-look and up-look cameras in a vicinity of another, opposite, corner of the die;
FIG. 2F illustrates an adjustment of the collet to align the die based on the images captured by the first and second down-look cameras and the up-look camera;
FIG. 3A is an example of a field of view of an up-look camera 24 relative to a field of view of a down-look camera, FIG. 3B shows an image captured by the up-look camera during a bonding process, FIG. 3C shows an image captured by the down-look camera during a bonding process;
FIGs. 4A to 4B illustrate exemplary images captured by the first and second down-look cameras at a position over a substrate onto which the die is to be bonded, and FIG. 4C illustrates an adjustment of the collet to align the die to the substrate based on the images captured of the substrate; and
FIG. 5 shows the die being bonded to the substrate.

### Detailed Description of the Preferred Embodiments of the Invention

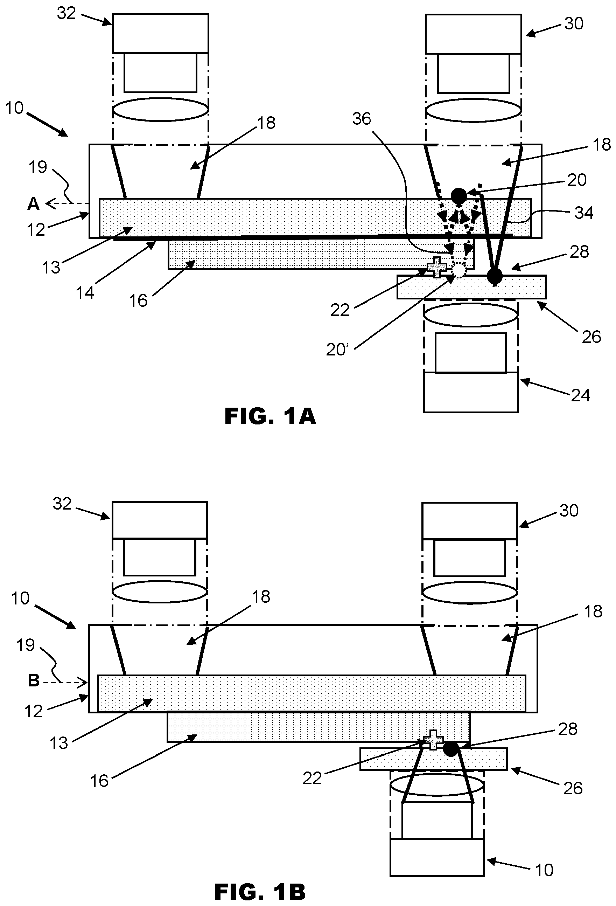

FIG. 1A is a side view of a die alignment system according to the preferred embodiment of the invention. The die alignment system is adapted for bonding a semiconductor die onto a bonding position on a surface, such as a surface of a substrate.

The die alignment system generally has a bond head 10 including a collet 12 that is configured to pick up and hold a semiconductor die 16, and for bonding the semiconductor die 16 onto a substrate thereafter. In use, the collet 12 is located between a first camera system (which may be in the form of a down-look camera system) which includes a first down-look camera 30 and a second down-look camera 32, and a second camera system (which may be in the form of an up-look camera system) which includes a single up-look camera 24. Both the first down-look camera 30 and an up-look camera 24 are shown to be viewing a reference plate 26 in FIG. 1A. The first and second down-look cameras 30,32 are respectively located adjacent to opposite corners of the collet 12 when the collet 12 is located between the first and second camera systems.

The collet 12 includes a see-through portion which allows light rays to travel through a body of the collet 12. One approach is to make the see-through portion from a transparent material incorporated in the body of the collet 12, such as by mounting a transparent glass plate 13 at the see-through portion. Whilst the glass plate 13 may extend throughout a thickness of the collet 12 to enable the first and second down-look cameras 30, 32 to see through the collet 12, through-hole openings 18 may also be formed along part of the thickness of the collet 12 to allow light rays to travel through the body of the collet 12. Where there are multiple down-look cameras 30, 32 in the first camera system, the collet 12 should include a plurality of see-through portions, each corresponding to a location of a respective camera comprised in the first camera system when the collet 12 is located between the first and second camera systems.

The transparent glass plate 13 preferably has a dichroic coating on a first surface thereof, in particular its bottom surface, and a plating including metallic fiducial marks on a second surface thereof, in particular its top surface. In one embodiment, the dichroic coating on the bottom surface of the glass plate 13 forms a reflective surface 14 for certain wavelengths of light within a specific range, whilst fiducials such as metallic dots or other fiducial patterns are plated on its top surface to form collet reference marks 20. The dichroic coating of the reflective surface 14 allows at least one wavelength of light (e.g., green light) to be reflected to the top surface of the glass plate 13, while another wavelength of light (e.g., red or blue light) is able to pass through the reflective surface 14. The dots or other fiducial patterns coated on the top surface should be arranged with a predetermined density that is suitable for the dots to be utilized as collet reference marks 20 with sufficient precision.

On a side of the bond head 10 that is opposite to the first and second down-look cameras 30, 32, the up-look camera 24 is positioned below a reference plate 26 that is made from a sheet of transparent material located between the bond head 10 and the up-look camera 24. With such an arrangement, the up-look camera 24 may view the semiconductor die 16 through the reference plate 26. The reference plate 26 may advantageously be mounted on top of the up-look camera 24 so that it is movable with the up-look camera 24 for the semiconductor die 16 and the reference plate marks to be concurrently viewable by the up-look camera 24 through the reference plate 26.

The reference plate 26 includes reference plate marks 28 formed on a surface of the sheet of transparent material, and preferably, the reference plate marks 28 are in the form of a plurality of dots or other pattern on the surface of the reference plate 26 which are viewable by the up-look camera 24 as well as the down-look cameras 30, 32. The plurality of dots may be in a matrix or grid pattern with an optimal concentration of dots that is required for a specific application that is envisaged. Other suitable shapes or patterns may also be used.

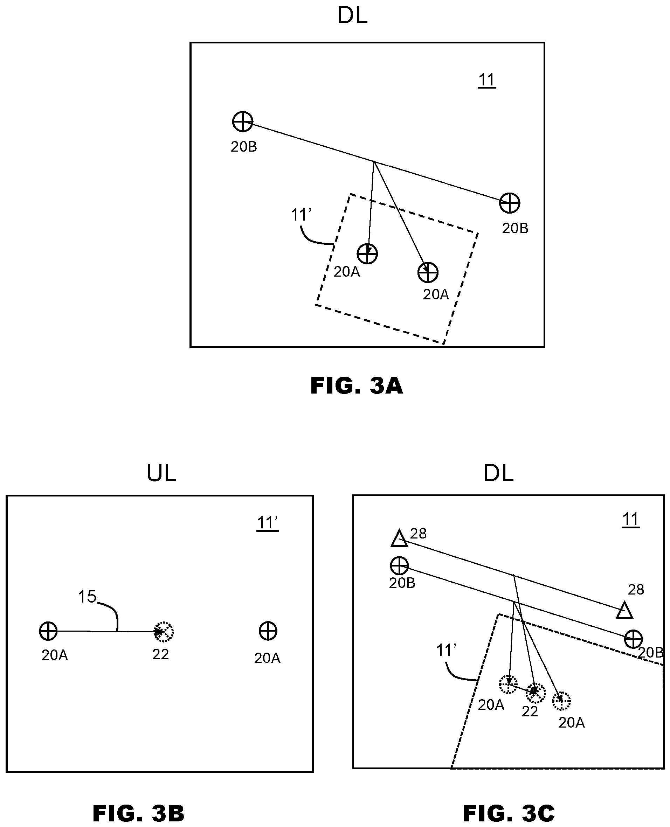

The collet 12 and the down-look cameras 30, 32 of the first camera system are preferably drivable together using a first motion system 17 (see FIG. 3A), whereas a second motion system 19 is preferably operative to drive only the collet 12 to move without moving the down-look cameras 30, 32.

The collet reference marks 20 on the upper surface of the glass plate 13 are viewable by the first and second down-look cameras 30, 32, and the semiconductor die 16 also includes die reference marks 22 on its lower surface that are viewable by the up-look camera 24. The semiconductor die 16 is locatable by the collet 12 so that the die reference marks 22 and the reference plate marks 28 are both within a depth of field of the up-look camera 24 for enabling simultaneous inspection.

FIG. 1A also shows that the collet reference marks 20 on the top surface of the transparent glass plate 13 is viewable by the first camera system, in this case the down-look camera 30, along a virtual optical path 36. Although the glass plate 13 of the collet 12 and the reference plate 26 are at different heights, a reflected image of the collet reference marks 20 that appears along the virtual optical path 36 and an image of the reference plate marks 28 being observed directly would both appear to the first and second down-look cameras 30, 32 as being at substantially a same height or level.

To achieve the aforesaid effect, the reflective surface 14 is located at such a distance from the collet reference marks 20 on the upper surface of the glass plate 13 that a reflection 20' of the collet reference marks 20 appears to the first down-look camera 30 to be at a height that is equivalent to a height of the reference plate marks 28, with the benefit that both the reference plate marks 28 and the reflection 20' of the collet reference marks 20 would appear to the first down-look camera 30 as being within a limited depth of field of the first down-look camera 30.

Therefore, the top surface where the collet reference marks 20 are formed is arranged at a height whereat a total distance travelled by a light ray between the collet reference marks 20 on the top surface to the first camera system via the bottom surface (where the reflective surface 14 is located) is similar to a total distance travelled by a light ray between the reference plate 26 and the first camera system, so that the collet reference marks 20 and the reference plate 26 are both within a depth of field of the first camera system. As a result, images of the collet reference marks 20 and the reference plate marks 28 on the reference plate 26 appear as being at substantially the same height or level. It should thus be appreciated that, in the preferred embodiment of the invention, the collet reference marks 20 should be illuminated by green light which is reflected by the reflective surface 14, whereas the reference plate marks 28 should be illuminated by red or blue light that is not so reflected but is instead able to pass through the reflective surface 14.

At the position of the bond head 10 shown in FIG. 1A, the collet 12 is shifted to the left in direction A using the second motion system 19 so that the semiconductor die 16 is shifted away from a field of view of the first down-look camera 30, and the first down-look camera 30 is then able to view the reference plate 26 through the opening 18 and the glass plate 13 without being blocked by the presence of the semiconductor die 16. It would be appreciated that such shifting motion would not be necessary if the semiconductor die 16 is not so large as to be blocking the down-look camera 30 from viewing the reference plate 26. In this position, the first down-look camera 30 is configured to view the reference plate marks 28 on the reference plate 26 along a first optical path 34.

Meanwhile, on the opposite side of the reference plate 26, the up-look camera 24 is correspondingly viewing the reference plate marks 28 on the reference plate 26 at the same time. The viewing of the reference plate marks 28 by the first down-look camera 30 and the up-look camera 24 at the same time helps to align a position of the first down-look camera 30 relative to a position of the up-look camera 24.

FIG. 1B is a side view of the die alignment system wherein the up-look camera 24 is viewing the transparent reference plate 26 as well as the semiconductor die 16 through the reference plate 26. In this position, the bond head 10 has been moved to the right in direction B so that both the die reference marks 22 as well as the reference plate marks 28 are within a field of view of the up-look camera 24. At this time, the reference plate marks 28 may be blocked from a view of the first down-look camera 30 by the semiconductor die 16, but a position and orientation of the semiconductor die 16 relative to the reference plate marks 28 is determinable from the image captured by the up-look camera 24. Meanwhile, the collet 12 is in a position where the first down-look camera 30 is operative to view the collet reference marks 20 to determine the position and orientation of the collet 12 corresponding to the determined position and orientation of the semiconductor die 16. Therefore, based on the images captured in FIG. 1A and FIG. 1B respectively, positions and/or orientations of the first down-look camera 30, up-look camera 24, collet 12, and semiconductor die 16 relative to the fixed reference plate marks 28 are all determinable.

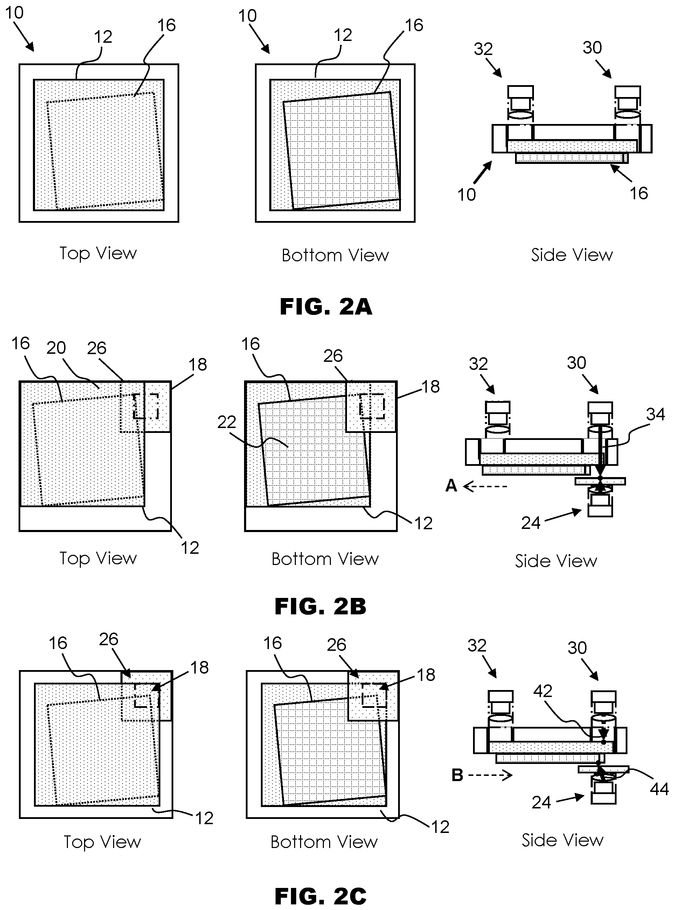

FIGs. 2A to 2C illustrate exemplary images captured by the up-look camera 24 and the first down-look camera 30 in a vicinity of one corner of the semiconductor die 16 when conducting a die pre-alignment process according to the preferred embodiment of the invention. The first down-look camera 30 of the first camera system views the collet 12 and the reference or glass plate 13 for determining a position and orientation of the collet 12 by referencing the collet reference marks 20 on the glass plate 13. In FIG. 2A, a top view of the bond head 10 provides a view of the glass plate 13 of the collet 12, and a portion of the unaligned semiconductor die 16 is viewable through the glass plate 13. As regards a bottom view of the bond head 10, it is similarly seen that an orientation of the semiconductor die 16 is out of a required alignment.

In FIG. 2B, the bond head 10 has been shifted to the left of the drawing in direction A using the second motion system 19, and the opening 18 is shown to be at a top right corner of the collet 12. From the top view, the reference plate 26 is schematically shown to be underneath the collet 12, but the reference plate marks 28 can still be seen by the first down-look camera 30 through the opening 18 along the first optical path 34. At the same time, an image of the collet reference marks 20 may optionally be captured by the first down-look camera 30 along the virtual optical path 36 if the collet reference marks 20 are within a field of view of the first down-look camera. From the bottom view, the up-look camera 24 correspondingly views the reference plate marks 28 on the reference plate 26. With these top and bottom images of the reference plate marks 28, a relationship can be constructed between the up-look camera 24 and the down-look cameras 30, 32 along the first optical path 34.

The up-look camera 24 of the second camera system should also view the semiconductor die 16 and the reference plate 26 for determining a position and orientation of the semiconductor die 16 relative to the reference plate 26. In FIG. 2C, the bond head 10 is shifted to the right in direction B using the second motion system 19 so that the die reference marks 22 of the semiconductor die 16 are moved into a field of view of the up-look camera 24. At this position, the first down-look camera 30 captures an image of the collet reference marks 20 from the top view along a second optical path 42 that is illuminated by a green light that is reflected by the reflective surface 14. On another side, the up-look camera 24 captures an image of the die reference marks 22 relative to the reference plate marks 28 along a third optical path 44 from the bottom view that is illuminated by red or blue light (which have wavelengths that are not reflected by the reflective surface 14).

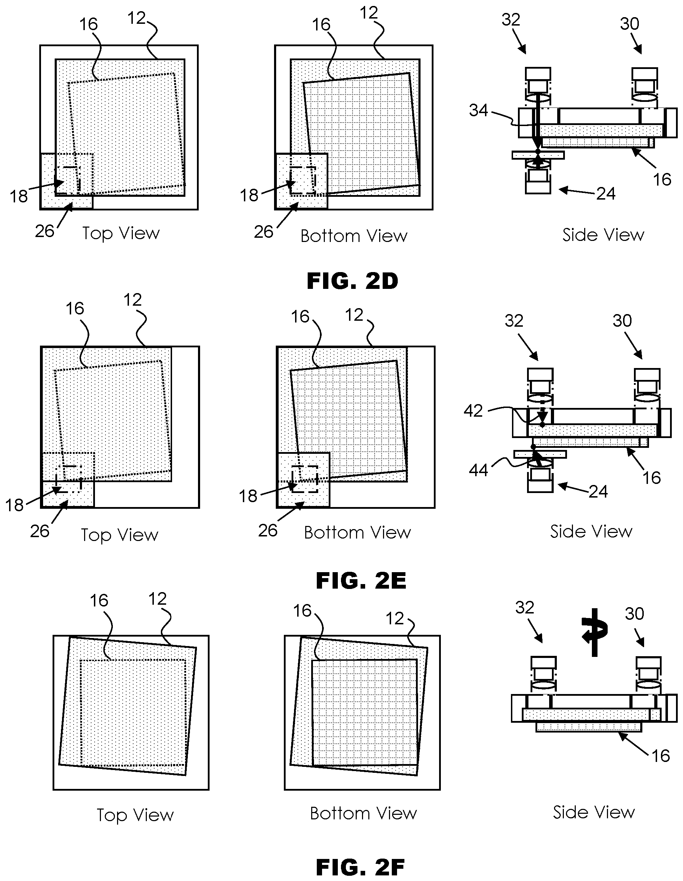

Thereafter, the bond head 10 is moved so that the second down-look camera 32 is now positioned above the reference plate 26 and the up-look camera 24 is viewing an opposite corner of the collet 12 as shown in FIG. 2D. At first, the bond head 10 is shifted to the right of the drawing, and the opening 18 is shown at a bottom left corner of the bond head 10. From the top view, the reference plate 26 is schematically shown to be underneath the collet 12, but the reference plate marks 28 can be seen by the first down-look camera 30 through the opening 18 along the first optical path 34 at this opposite corner of the collet 12. At the same time, an image of the collet reference marks 20 may optionally be captured by the second down-look camera 32 along the virtual optical path 36 if the collet reference marks 20 are within a field of view of the second down-look camera 32. From the bottom view, the up-look camera 24 correspondingly views the reference plate marks 28 on the reference plate 26 which is underneath the opening 18.

In FIG. 2E, the bond head 10 is shifted to the left so that the die reference marks 22 of the semiconductor die 16 is moved into a field of view of the up-look camera 24. At this position, the second down-look camera 32 captures an image of the collet reference marks 20 from the top view, while the up-look camera 24 captures an image of the die reference marks 22 relative to the reference plate marks 28 from the bottom view.

In FIG. 2F, based on the orientation of the semiconductor die 16 as determined from the images of its opposite corners that are captured as described with reference to FIG. 2C and FIG. 2E, the bond head 10 is moved linearly in XY directions along a horizontal plane and rotated (if necessary) such that the semiconductor die 16 is pre-aligned into a desired orientation to an adequate level of accuracy.

It would be appreciated that an extent of the field of view of the first or second down-look camera 30, 32 and of the up-look camera 24 are often different. If so, there may be difficulty in associating the collet reference marks 20 with the die reference marks 22 on a semiconductor die 16 when only some of the collet reference marks 20 within the field of view of the down-look camera 30, 32 are within the field of view of the up-look camera 24. Moreover, the die reference marks 22 on the semiconductor die 16 cannot be viewed directly by the first and second down-look cameras 30, 32 when the semiconductor die 16 is being held by the collet 12 for determining an offset of the semiconductor die 16.

FIG. 3A is an example of a field of view 11' of the up-look camera 24 being different from a field of view 11 of the first or second down-look camera 30, 32. In particular, the former field of view 11' is smaller than the latter field of view 11.

Calibration is first conducted by capturing with the down-look camera one or more images of all the collet reference marks 20 that are within a field of view of the down-look camera 30, 32. In this example, two or more central collet reference marks 20A are within the field of view 11' of the up-look camera 24. Additionally, included in the image are two or more peripheral collet reference marks 20B which are outside the field of view 11' of the up-look camera 24.

Positions of the peripheral collet reference marks 20B outside the field of view 11' are determined relative to the central collet reference marks 20A that are inside the field of view 11'. The positions of these central and peripheral collet reference marks 20A, 20B are recorded and averaged for creating translation vectors corresponding to their relative positions.

FIG. 3B shows an image captured by the up-look camera 24 within its field of view 11', which includes a die reference mark 22 when the semiconductor die 16 is being held by the collet 12, and the central collet reference marks 20A. A translation vector 15 is calculated between the die reference mark 22 and at least one of the central collet reference marks 20A. Since they are generated based on calculations that make reference to a rigid body, the use of translation vectors 15 ensures consistent measurements notwithstanding multiple bonding cycles having been conducted.

FIG. 3C shows an image captured by the down-look camera 30, 32 within its field of view 11, as compared with the field of view 11' of the up-look camera 24 when the semiconductor die 16 is present. The reference marks that are viewable by the down-look camera 30, 32 include the reference plate marks 28 and the central and peripheral collet reference marks 20A, 20B. However, the die reference mark 22 is on an opposite side of the semiconductor die 16 facing the up-look camera 24 and is not visible to the down-look camera 30, 32.

Based on the field of view 11' of the up-look camera 24, the position of the die reference mark 22 relative to the central collet reference marks 20A is determined. Through calibration from the image in FIG. 3A, when the position of the die reference mark 22 relative to the central collet reference marks 20A (and thus the peripheral collet reference marks 20B) is determinable. Thus, the projected position of the die reference mark 22 that is identical to the position of the die reference mark 22 that has been obtained by directly viewing it with the up-look camera 24 can be compared and any differences may be accounted for.

After calculating the position of the die reference mark 22 from both the up-look (FIG. 3B) and down-look (FIG. 3C) images, its actual distance from one or more central collet reference marks 20A is recorded. This information may be used to determine a position and orientation of an entire semiconductor die 16, after the positions of at least two opposite corners of the semiconductor die 16 have been inspected. A precise position of the semiconductor die 16 relative to the collet 12 may then be determined. Such an approach overcomes any constraints from the limited field of view 11' of the up-look camera 24. After calculating the position of the semiconductor die 16, as well as its orientational offset relative to the collet 12, die position adjustment may be accurately conducted.

Generally, the above pre-alignment process would be able to achieve a level of accuracy of up to 1 micron or less. To ensure that such a level of accuracy has been achieved, the processes as described in FIGs. 2B to 2F can be repeated any number of times until the required level of accuracy of 1 micron or less is achieved.

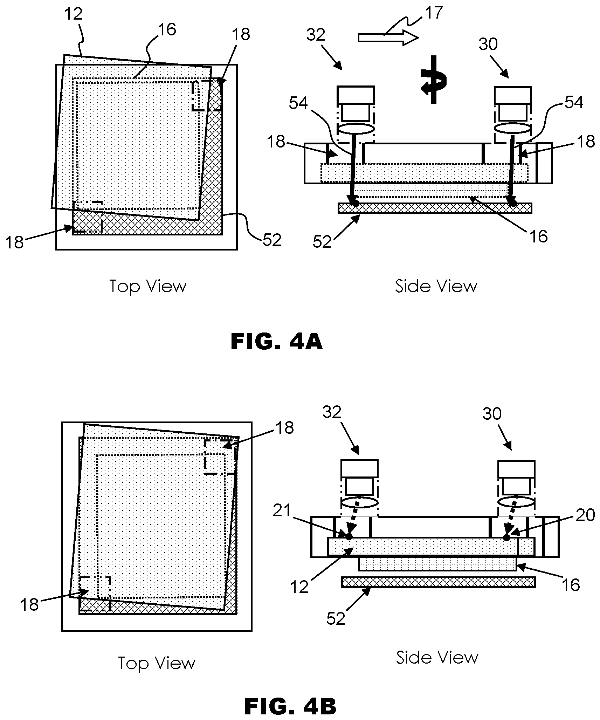

After the level of pre-alignment accuracy has been achieved with respect to the semiconductor die 16 alone, the semiconductor die 16 should then be aligned with respect to a bonding position on a substrate 52 that it is to be bonded to. FIGs. 4A to 4B illustrate exemplary images captured by the first and second down-look cameras 30, 32 at a position over a bonding position on the substrate 52 onto which the semiconductor die 16 is to be bonded.

In FIG. 4A, the bond head 10 together with the collet 12 and the down-look cameras 30, 32 have been positioned by the first motion system 17 to a position above the bonding position on the substrate 52. The first down-look camera 30 of the first camera system may then view the bonding position on the substrate 52 for determining a position and orientation of the bonding position, so that the position and orientation of the bonding position relative to the positions and orientations of the collet 12 and the semiconductor die 16 may be determined.

The bond head 10 is first shifted diagonally towards the top-left of the drawing using the second motion system 19 so that opposite corners of the substrate 52 are viewable by the first down-look camera 30 through the opening 18 at one corner of the bond head 10 and by the second down-look camera 32 through the opening 18 at an opposite corner of the bond head 10, along fifth optical paths 54 extending respectively between the first down-look camera 30 and the substrate 52. It should be noted that if an area of the semiconductor die 16 does not block the first and second down-look cameras 30, 32 from viewing opposite corners of the substrate 52, there may be no need to shift the bond head 10 at all with the second motion system 19 in order for the first and second down-look cameras 30, 32 to view the substrate 52.

In FIG. 4B, the bond head 10 is shifted diagonally towards the bottom-right of the drawing using the second motion system 19 so that the collet reference marks 20, 21 on the collet 12 are viewable by the respective first and second down-look cameras 30, 32 from a top view.

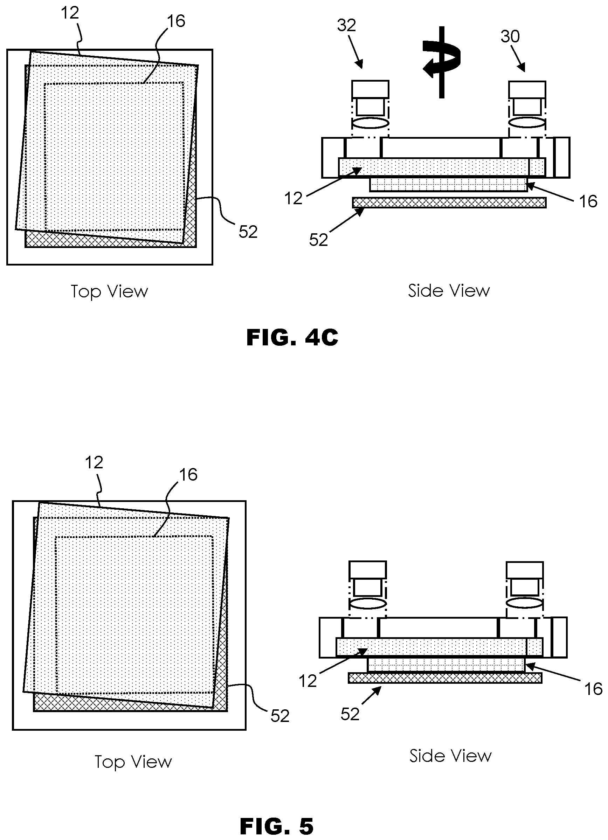

As the positions and orientations of the collet reference marks 20, 21 relative to the die reference marks 22 on the semiconductor die 16 are known from FIGs. 2B to 2E, and the positions and orientation of the collet reference marks 20, 21 relative to the bonding position on the substrate 52 are known, it is possible to accurately align the semiconductor die 16 to the bonding position. After such determination of any relative misalignment, FIG. 4C illustrates an adjustment of the bond head 10 to adjust the position and orientation of the semiconductor die 16 with the collet 12 so as to align the semiconductor die 16 to the substrate 52 based on the images captured of the bonding position on the substrate 52.

The above alignment process conducted between the semiconductor die 16 and bonding position would be able to achieve a level of accuracy of 50 nanometers or less. To ensure that such a level of accuracy has been achieved, the processes as described in FIGs. 4A to 4C can be repeated any number of times until the required level of accuracy of less than 50 nanometers is achieved.

Once the level of accuracy has been achieved, the semiconductor die 16 is bonded onto the bonding position on the substrate 52 with high precision and accuracy as shown in FIG. 5, wherein the collet 12 has been manipulated so that the orientation of the semiconductor die 16 is accurately aligned with that of the bonding position on the substrate 52.

It should be appreciated that the alignment apparatus and method according to the described embodiment of the requires a relatively small depth of field, and therefore a larger numerical aperture can be achieved to attain high alignment precision without incurring high component costs. Further precision is attained by relating the collet reference marks 20 and the die reference marks 22 to the same reference plate marks 28.

The pre-alignment of the semiconductor die 16 with respect to the reference plate 26 which is mounted over the up-look camera 24 allows pre-alignment to be conducted relative to the reference plate marks 28 to minimize errors due to factors such as distortion, aberration, module deformation or thermal drift that may arise through use. Further, the reference plate marks 28 reduces sensitivity to tilting of the up-look and down-look cameras 24, 30, 32, and simplifies a design of the up-look camera 24 without the necessity to adapt it to view reference marks that are located at different object levels.

Moreover, the alignment system secures long-term bonding accuracy and precision is significantly improved compared to prior art systems without adversely affecting bonding speed.

The invention described herein is susceptible to variations, modifications and/or additions other than those specifically described and it is to be understood that the invention includes all such variations, modifications and/or additions which fall within the spirit and scope of the above description.

## Claims

1. A method of bonding a semiconductor die onto a bonding position on a surface, the method comprising the steps of:
picking up the semiconductor die with a collet;
locating the collet between a first camera system and a second camera system;
viewing the collet and a reference plate with the first camera system and determining a position and orientation of the collet relative to the reference plate when the collet is holding the semiconductor die;
viewing the semiconductor die and the reference plate with the second camera system and determining a position and orientation of the semiconductor die relative to the reference plate;
moving the collet to a position above the bonding position;
viewing the bonding position with the first camera system and determining a position and orientation of the bonding position relative to the position and orientation of the collet and the position and orientation of the semiconductor die; and thereafter
adjusting the position and orientation of the semiconductor die with the collet and bonding the semiconductor die onto the bonding position.

2. The method as claimed in claim 1, wherein the first camera system comprises a down-look camera system and the second camera system comprises an up-look camera system.

3. The method as claimed in claim 1, wherein the collet includes a see-through portion which allows light rays to travel through a body of the collet.

4. The method as claimed in claim 3, wherein the see-through portion comprises a transparent material.

5. The method as claimed in claim 4, wherein the transparent material comprises a transparent plate having a dichroic coating on a first surface thereof to form a reflective surface only for certain wavelengths of light within a specific range.

6. The method as claimed in claim 5, wherein the transparent plate comprises a second surface opposite to the first surface, the second surface including collet reference marks.

7. The method as claimed in claim 6, wherein the collet reference marks are formed by plating a metallic pattern onto the second surface.

8. The method as claimed in claim 6, wherein the second surface is arranged at a height whereat a total distance travelled by a light ray between the second surface to the first camera system via the first surface is similar to a total distance travelled by a light ray between the reference plate and the first camera system, so that the collet reference marks and the reference plate are both within a depth of field of the first camera system.

9. The method as claimed in claim 8, wherein images of the collet reference marks and the reference plate appear as being at substantially a same height or level.

10. The method as claimed in claim 1, wherein the reference plate comprises a sheet of transparent material, and reference plate marks formed on a surface of the sheet of transparent material.

11. The method as claimed in claim 10, wherein the reference plate marks comprise a plurality of dots or other fiducial patterns.

12. The method as claimed in claim 10, wherein the sheet of transparent material is mounted on top of the second camera system such that the semiconductor die and reference plate marks are concurrently viewable by the second camera system through the reference plate.

13. The method as claimed in claim 1, wherein the first camera system is movable together with the collet while being driven by a first motion system, and the collet is drivable by a second motion system to move without moving the first camera system.

14. The method as claimed in claim 13, further comprising the step of driving the collet with the second motion system to shift the semiconductor die away from a field of view of the first camera system prior to viewing the reference plate with the first camera system.

15. The method as claimed in claim 14, wherein the collet includes a plurality of see-through portions, each corresponding to a location of a respective camera comprised in the first camera system, when the collet is located between the first and second camera systems.

16. The method as claimed in claim 1, wherein the first camera system comprises first and second cameras respectively located adjacent to opposite corners of the collet when the collet is located between the first and second camera systems.

17. An apparatus for bonding a semiconductor die onto a bonding position on a surface, the apparatus comprising:
a collet for picking up the semiconductor die;
a first camera system and a second camera system; and
a reference plate;
wherein when the collet is holding the semiconductor die between the first and second camera systems, the first camera system is operative to view the collet and the reference plate for determining a position and orientation of the collet relative to the reference plate and the second camera system is operative to view the semiconductor die and the reference plate for determining a position and orientation of the semiconductor die relative to the reference plate; and
wherein when the collet is moved to a position above the bonding position, the first camera system is further operative to view the bonding position for determining a position and orientation of the bonding position relative to the position and orientation of the collet and the position and orientation of the semiconductor die prior to adjusting the position and orientation of the semiconductor die with the collet and bonding the semiconductor die onto the bonding position.
